Europäisches Patentamt

European Patent Office

Office européen des brevets

(19)

(11) Veröffentlichungsnummer: **0 265 642 B1**

(12) # EUROPÄISCHE PATENTSCHRIFT

(45) Veröffentlichungstag der Patentschrift: **25.03.92**

(51) Int. Cl.5: **H01L 31/107**

(21) Anmeldenummer: **87113301.3**

(22) Anmeldetag: **11.09.87**

(54) **Lawinen-photodiode.**

(30) Priorität: **13.09.86 DE 3631248**

(43) Veröffentlichungstag der Anmeldung:
**04.05.88 Patentblatt 88/18**

(45) Bekanntmachung des Hinweises auf die Patenterteilung:
**25.03.92 Patentblatt 92/13**

(84) Benannte Vertragsstaaten:
**DE FR GB IT NL**

(56) Entgegenhaltungen:
**FR-A- 2 406 895**

**FREOUENZ, Band 38, Nr. 9, September 1984, Seiten 212-216, St. Peter-Ording, DE; R. TROMMER: "Design and fabrication of InGaAs/Inp avalanche photodiodes for the 1 to 1.6 mum wavelength region"**

**SIEMENS FORSCHUNGS- UND ENTWICKLUNGS-BERICHT, Band 11, Nr. 4, 1982, Seiten 204-208, Springer-Verlag; R. TROMMER et al.: "Liquid-phase epitaxy of (In,Ga)(As,P) and (In,Ga) As on InP in the 1.3mum to 1.65mum wavelength range"**

**NINTH EUROPEAN CONFERENCE ON OPTI-**

**CAL COMMUNICATION (ECOC 83), Geneva, 23rd-26th Oktober 1983, Seiten 163-166, North-Holland, Amsterdam, NL; K. BÖHM et al.: "Pulse response of back-illuminated GaI-nAs pin-photodiodes"**

(73) Patentinhaber: **Standard Elektrik Lorenz Aktiengesellschaft**
**Lorenzstrasse 10**
**W-7000 Stuttgart 40(DE)**

(84) Benannte Vertragsstaaten:
**DE**

(73) Patentinhaber: **ALCATEL N.V.**
**Strawinskylaan 537 (World Trade Center)**
**NL-1077 XX Amsterdam(NL)**

(84) Benannte Vertragsstaaten:
**FR GB IT NL**

(72) Erfinder: **Kuebart Wolfgang**
**Köllestrasse 36A**
**W-7000 Stuttgart 1(DE)**

(74) Vertreter: **Pohl, Herbert, Dipl.-Ing et al**
**Standard Elektrik Lorenz AG Patent- und Lizenzwesen Postfach 30 09 29**
**W-7000 Stuttgart 30(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 265 642 B1

EP 0 265 642 B1

**Beschreibung**

Die Erfindung betrifft eine Lawinen-Photodiode gemäß dem Oberbegriff des Anspruchs 1 und ein Verfahren zur Herstellung einer Lawinen-Photodiode gemäß dem Oberbegriff des Anspruchs 5.

Es ist aus der Zeitschrift "der elektroniker", Mai 1986, S 33 ff. mit dem Titel "Fotodetektoren für die optische Nachrichtenübertragung" eine Lawinen-Photodiode bekannt, die ein $n^+$-InP-Substrat aufweist, auf dem eine n-InP-Schicht, eine $n^-$-InGaAsP-Schicht als Absorptionszone, eine Gradientenschicht mit einer Zusammensetzung von InGaAsP bis InP, eine n-InP-Schicht als Multiplikationszone und eine $p^+$-InP-Schicht aufgebracht sind. Die bekannte Lawinen-Photodiode ist als eine sich nach oben verjüngende Mesa-Lawinen-Photodiode ausgebildet und weist auf der Mesa einen ersten und auf der Unterseite des $n^+$-InP-Substrats einen zweiten Metallkontakt mit kreisförmiger Öffnung auf, wobei die kreisförmige Öffnung eine Antireflexionsschicht umschließt, durch die das Licht in die Lawinen-Photodiode eingestrahlt wird. Eine Passivierungsschicht aus Polyimid bedeckt die auf der oberen Seite des $n^+$-InP-Substrats angeordneten Halbleiterschichten.

Diese bekannte Lawinen-Photodiode weist den Nachteil auf, daß es in den Randbereichen der Mesa, vor allem in der Multiplikationszone, zu durch Feldüberhöhung hervorgerufenen elektrischen Randdurchbrüchen kommt, die zu einem hohen Eigenrauschen und zu einer Verkürzung der Lebensdauer der Lawinen-Photodiode führen.

Der Erfindung liegt die Aufgabe zugrunde, eine Lawinen-Photodiode mit geringerem Eigenrauschen und größerer Lebensdauer und ein Verfahren zu ihrer Herstellung zu schaffen.

Die Aufgabe wird bei einer gattungsgemäßen Vorrichtung durch das kennzeichnende Merkmal des Anspruchs 1 und bei einem gattungsgemäßen Verfahren durch die kennzeichnenden Merkmale des Anspruchs 5 gelöst.

Weitere Ausgestaltungen der Erfindung sind den übrigen Ansprüchen und der Beschreibung zu entnehmen.

Jeweils ein Ausführungsbeispiel der erfindungsgemäßen Lawinen-Photodiode und des erfindungsgemäßen Verfahrens zur Herstellung einer Lawinen-Photodiode sind nachstehend anhand der Figuren 1 bis 3 näher beschrieben. Es zeigen:

Fig. 1 ein Ausführungsbeispiel der erfindungsgemäßen Lawinen-Photodiode,

Fig. 2 die Lawinen-Photodiode nach der Durchführung bekannter Verfahrensschritte, und

Fig. 3 die Lawinen-Photodiode nach einem ersten erfindungsgemäßen Verfahrensschritt.

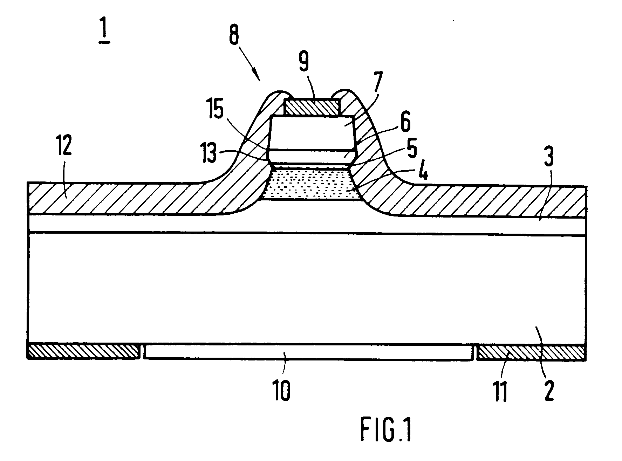

In Fig. 1 ist das Ausführungsbeispiel der erfindungsgemäßen Lawinen-Photodiode 1 abgebildet. Auf der oberen Seite eines $n^+$-InP-Substrats 2 ist eine n-InP-Schicht 3 als Pufferzone angeordnet. Darauf befindet sich eine $n^-$-InGaAsP-Schicht 4 als Absorptionszone, auf der eine Gradientenschicht 5 mit einer Zusammensetzung von InGaAsP bis InP und eine n-InP-Schicht 6 als Multiplikationszone angeordnet sind. Auf der Multiplikationszone 6 ist eine $p^+$-InP-Schicht 7 zur Bildung des pn-Übergangs angebracht. Die n-InP-Schicht 3 ist teilweise und die darüber angeordneten Halbleiterschichten sind voll als rotationssymmetrische Mesa (8) ausgebildet. Der Durchmesser der Mesa 8 liegt im Bereich unter 0,1 mm. Die Mesa 8 weist eine Pilzstruktur auf. Sie weist in der Pufferzone 3 und der Absorptionszone 4, teilweise in der Gradientenschicht 5 und in der $p^+$-InP-Schicht 7 nach oben hin eine Verjüngung und teilweise in der Gradientenschicht 5 und in der Multiplikationszone 6 einen Überhang 13 auf. Unter Überhang 13 ist vom $n^+$-InP-Substrat 2 her betrachtet mit zunehmender Höhe eine Verbreiterung der Mesa 8 zu verstehen. Auf der Mesa 8 ist ein zweischichtiger Metallkontakt 9 angebracht, wobei die untere Schicht eine Zink-Gold-Legierung und die obere Schicht eine Goldschicht ist. Im Bereich der Mesa 8, auf der unteren Seite des $n^+$-InP-Substrats 2 ist eine rotationssymmetrische $SiO_2$-Schicht 10 als Antireflektionsschicht angebracht. Die $SiO_2$-Schicht ist von einem, auf das $n^+$-InP-Substrat 2 aufgebrachten Metallkontakt 11 mit kreisförmiger Öffnung umgeben. Eine Passivierungsschicht 12 aus Polyimid ist auf den noch frei liegenden Teilen der Halbleiterschichten 3 bis 7 aufgebracht. Die einzelnen Schichten weisen die nachstehend aufgeführten Parameter auf.

| Schicht mit Bezugzeichen | Dotierstoff | Konzentration d.Dotierstoffs k [cm$^{-3}$] | Schichtdicke [μm] |
|---|---|---|---|
| $n^+$-InP-Substrat 2 | Sn, S | $k_n > 10^{18}$ | 150 |
| n-InP-Schicht 3 | Sn | $k_n < 10^{17}$ | 1-2 |
| $n^-$-InGaAsP-Schicht 4 | | $k_n < 5.10^{15}$ | 3 |
| Gradientenschicht 5 | | | 0,4 |
| n-InP-Schicht 6 | Sn | $k_n \approx 2\text{-}4.10^{16}$ | 0,8 |
| $p^+$-InP-Schicht 7 | Be,Cd,Zn | $k_p > 10^{18}$ | 1,5 |

2

Die vorgeschlagene Lawinen-Photodiode 1 eignet sich aufgrund der verwendeten Werkstoffe zum Nachweis von Licht im Spektralbereich der Wellenlängen zwischen 1000 nm und 1600 nm. Dazu wird die Lawinen-Photodiode 1 in Sperrichtung betrieben. Mit den angegebenen Schichtparametern und einer angelegten Spannung von U ≈ 30-50 V entsteht eine von der Multiplikationszone 6 bis in die Absorptionszone 4 reichende elektrische Feldzone. Die Gradientenschicht 5 unterdrückt energetische Ladungsträgerfallen in der Bandstruktur, die bei einem direkten Kontakt zwischen einer InGaAsP-Schicht und einer InP-Schicht vorhanden wären und einen negativen Einfluß auf die Quantenausbeute und das Zeitverhalten hätten. Durch die $SiO_2$-Schicht 10 einfallendes Licht wird in der Absorptionszone 4 absorbiert und generiert dabei Elektron-Loch-Paare. Die Elektron-Loch-Paare werden durch das Feld der angelegten elektrischen Spannung getrennt, wobei die Löcher in die Multiplikationszone 6 beschleunigt werden und dort durch Stöße neue Elektronen-Loch-Paare generieren, was zu einer lawinenartigen Zunahme des Photostroms führt.

Durch den Überhang 13 im Bereich der Multiplikationszone 6 wird eine Feldüberhöhung am Rand der Mesa 8 verkleinert und somit die Gefahr von Randdurchbrüchen reduziert. Es ist durchaus von Vorteil, wenn die Mesa 8 nicht nur einen Überhang an der Gradientenschicht 5 und der Multiplikationszone 6, sondern auch noch an der $p^+$-InP-Schicht 7 aufweist. Die Pilzstruktur ist immer dann von Vorteil, wenn eine Lawinen-Photodiode eine sich grundsätzlich nach oben verjüngende Mesa 8 und eine über der Absorptionszone angeordnete Multiplikationszone mit einer hochdotierten Deckschicht wie der $p^+$-InP-Schicht (7) aufweist. Dieser Vorteil tritt unabhängig vom Werkstoff der Lawinen-Photodiode auf.

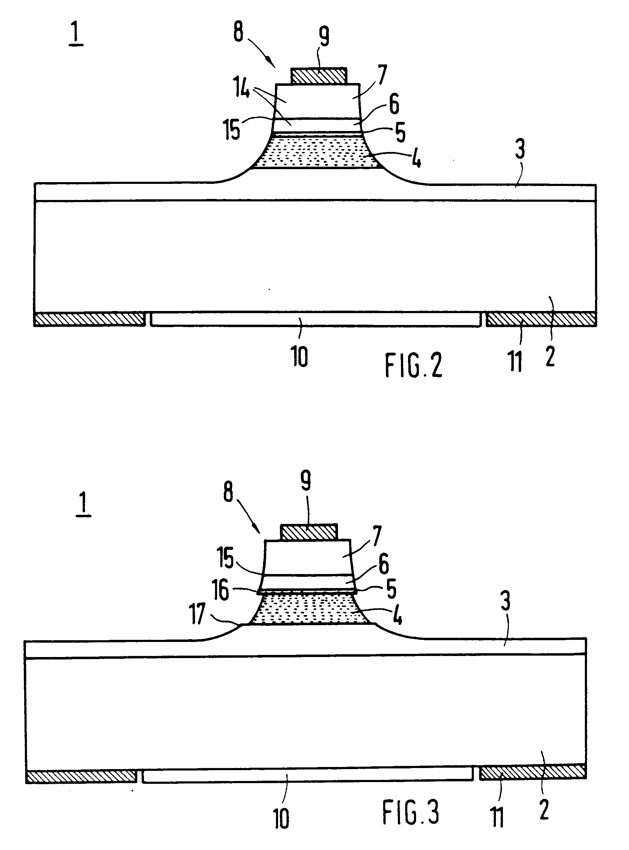

Beim erfindungsgemäßen Herstellungsverfahren der Lawinen-Photodiode 1 wird auf dem $n^+$-InP-Substrat 2 die n-InP-Schicht 3 und darauf die $n^-$-InGaAsP-Schicht 4 mittels Epitaxie abgeschieden. Auf die $n^-$-InGaAsP-Schicht 4 wird die Gradientenschicht 5 bestehend aus einer Zusammensetzung von InGaAsP bis InP und anschließend eine n-InP-Schicht 14 abgeschieden. Wird die n-InP-Schicht 14 mittels Flüssigphasenepitaxie abgeschieden, dient die Gradientenschicht 5 als sogenannte "antimeltback layer", die beim Abscheiden der InP-Schicht 14 ein Auflösen der $n^-$-InGaAsP-Schicht 4 in der InP-Schmelze verhindert. Durch Diffusion von Cadmium bei T = 660°C wird der pn-Übergang 15 in der n-InP-Schicht 14 gebildet, wobei die n-InP-Schicht 14 in die n-InP-Schicht 6 und die $p^+$-InP-Schicht 7 unterteilt wird. Nach den Epitaxie- und Dotierschritten erfolgt das beidseitige Beschichten der Lawinen-Photodiode mit $SiO_2$, die anschließende Strukturierung fensterartiger Aussparungen für die Metallkontakte 9, 11 und das Aufbringen der Metallkontakte 9, 11 mittels Aufdampfen oder Aufstäuben. Die $SiO_2$-Schicht auf der Oberseite wird anschließend entfernt, die $SiO_2$-Schicht 10 auf der Unterseite des $n^+$-InP-Substrats 2 bleibt als Antireflexionsschicht bestehen. Zur Strukturierung der Mesa 8 wird eine Photolackmaske aufgebracht und die Halbleiterschichten anschließend in wässriger Ätzlösung $10HBr : 10H_2O : 1H_2O_2$ bei T = 23°C 2 bis 3 Minuten bis in die n-InP-Schicht 3 geätzt. Hierbei entsteht die Mesa 8 nach Fig. 2. Durch selektives Unterätzen der InP-Schichten 6, 7 der Lawinen-Photodiode in $1H_2SO_4 : 6H_2O_2 : 10H_2O$ bei T = 23°C über eine Zeit von t = 8 min entstehen, wie in Fig. 3 gezeigt, überstehende Kanten 16 und 17 an der n-InP-Schicht 3 und der Gradientenschicht 5. Durch Politurätzen in $10HBr : 10H_2O : 1H_2O_2$ bei T = 23°C für t = 10 s werden vor allem diese Kanten 16, 17 abgetragen, wobei aus der Kante 16 der Überhang 13 entsteht. Nach dem Entfernen der Photolackmaske zur Strukturierung der Mesa 8 erfolgt das Aufbringen der Passivierungsschicht 12 aus Polyimid, wobei der Metallkontakt 9 frei bleibt.

## Patentansprüche

1. Lawinen-Photodiode mit einem Halbleitersubstrat (2), einer Schicht als Absorptionszone (4), einer Schicht als Multiplikationszone (6), alle von einem Leitungstyp und einer Schicht (7) vom anderen Leitungstyp, wobei die Schichten in genannter Reihenfolge aufeinander angeordnet und als Mesa (8) ausgebildet sind, **dadurch gekennzeichnet,** daß die Mesa vom Halbleitersubstrat (2) her betrachtet mit zunehmender Höhe wenigstens teilweise in der Multiplikationszone (6) eine Verbreiterung (13) aufweist, wodurch elektrische Randdurchbrüche reduziert werden.

2. Lawinen-Photodiode nach Anspruch 1, dadurch gekennzeichnet, daß die Mesa (8) in der Multiplikationszone (6) und wenigstens teilweise in der Schicht (7) vom anderen Leitungstyp einen Überhang aufweist.

3. Lawinen-Photodiode nach Anspruch 1 oder 2, dadurch gekennzeichnet, daß das Halbleitersubstrat ein $n^+$-InP-Substrat (2) ist und daß das nachzuweisende Licht vorzugsweise durch das $n^+$-InP-Substrat (2) einstrahlbar ist.

4. Lawinen-Photodiode nach einem der Ansprüche 1 bis 3, dadurch gekennzeichnet, daß auf dem $n^+$-InP-Substrat (2) eine n-InP-Schicht (3) als Pufferzone, darauf eine $n^-$-InGaAsP-Schicht (4) als Absorptionszone, darauf eine Gradientenschicht (5) unterschiedlicher Zusammensetzung von InGaAsP bis InP als Zwischenschicht, darauf eine n-InP-Schicht (6) als Multiplikationszone und darauf eine $p^+$-InP-Schicht (7) angeordnet sind, daß auf der obersten Schicht ein Metallkontakt (9) und eine die gesamten Halbleiterschichten überdeckende Passivierungsschicht (12) angeordnet sind, und daß auf der Rückseite des $n^+$-InP-Substrats (2) ein Metallkontakt (11) mit kreisförmiger Öffnung eine Antireflexionsschicht (10) umschließend angeordnet ist.

5. Verfahren zur Herstellung einer Lawinen-Photodiode nach Anspruch 1 durch Aufbringen einer Schicht als Pufferzone (3), einer Schicht als Absorptionszone (4), einer Gradientenschicht (5) und einer weiteren Schicht (14) auf ein Halbleitersubstrat (2), wobei alle Schichten von einem Leitungstyp und in der genannten Reihenfolge aufeinander angeordnet sind, durch Dotieren des oberen Teils der weiteren Schicht (14) von einem Leitungstyp zum anderen Leitungstyp, zur Erzeugung einer Multiplikationszone (6) von einem Leitungstyp und einer Schicht (7) vom anderen Leitungstyp und durch Ätzen einer sich nach oben verjüngenden Mesa (8), **gekennzeichnet durch** zusätzliche Verfahrensschritte:
- Reduzieren des Querschnitts der Mesa (8) im Bereich der Absorptionszone (4) und teilweise in der Gradientenschicht (5) durch selektives Ätzen,
- Reduzieren des gesamten Querschnitts der Mesa (8) durch Politurätzen, wobei die durch das selektive Ätzen entstandenen Kanten (16, 17) am stärksten abgetragen werden.

6. Verfahren zur Herstellung einer Lawinen-Photodiode nach Anspruch 5, gekennzeichnet durch folgende Verfahrensschritte:
- Aufbringen einer n-InP-Schicht (3) auf ein $n^+$- InP-Substrat (2) mittels Epitaxie,
- Aufbringen einer $n^-$-InGaAsP-Schicht (4) mittels Epitaxie,
- Aufbringen der Gradientenschicht (5) mit einer Zusammensetzung von InGaAsP bis InP mittels Epitaxie,
- Aufbringen einer n-InP-Schicht (14) mittels Epitaxie,
- Ausbilden des oberen Teils der n-InP-Schicht (14) zu einer $p^+$-InP-Schicht (7) durch Diffusion,
- Aufbringen eines Metallkontakts (9) auf der $p^+$-InP-Schicht,
- Strukturieren einer Mesa (8) mit Hilfe einer Photolackabdeckung und durch isotropes Ätzen,
- Reduzieren des Querschnitts der $n^-$-InGaAsP-Schicht (4) und teilweise des Querschnittes der Gradientenschicht (5) durch selektives Ätzen,
- Reduzieren des gesamten Querschnitts der Mesa (8) durch Politurätzen.

## Claims

1. Avalanche photodiode comprising a semiconductor substrate (2), a layer as an absorption region (4), a layer as a multiplication region (6), all of one conductivity type, and a layer (7) of the other conductivity type, the layers being arranged on top of one another in said order and forming a mesa (8), **characterized in** that the mesa, viewed from the semiconductor substrate (2), has a widened portion (13) at least in part of the multiplication region (6), whereby electric surface breakdowns are reduced.

2. An avalanche photodiode as claimed in claim 1, characterized in that the mesa (8) has an overhanging portion in the multiplication region (6) and at least in part of the layer (7) of the other conductivity type.

3. An avalanche photodiode as claimed in claim 1 or 2, characterized in that the semiconductor substrate is an $n^+$ InP substrate (2), and that the light to be detected is preferably incident through the $n^+$ InP substrate (2).

4. An avalanche photodiode as claimed in claims 1 to 3, characterized in that the $n^+$ InP substrate (2) is covered by an n InP layer (3) as a buffer region, that the n InP layer (3) is covered by an $n^-$ InGaAsP layer (4) as the absorption region, that the $n^-$ InGaAsP layer (4) is covered by a graded-index layer (5) of different composition from InGaAsP to InP as an intermediate layer, that the graded-index layer (5) is covered by an n InP layer (6) as the multiplication region, that the n InP layer (6) is covered by a $p^+$ InP layer (7), that the top layer carries a metal contact (9), that all semiconductor layers are covered by a passivating layer (12), and that the underside of the $n^+$ InP substrate (2) is provided with a metal contact (11) having a circular opening surrounding an antireflection coating (10).

5. Method of making an avalanche photodiode as claimed in claim 1 by depositing a layer as a buffer region (3), a layer as an absorption region (4), a graded-index layer (5), and an additional layer (14) on a semiconductor substrate (2), all of said layers being of one conductivity type and arranged one on top of the other in said order, by doping the upper portion of the additional layer (14) to change it from said one conductivity type to the other conductivity type in order to form a multiplication region (6) of said one conductivity type and a layer (7) of said other condctuvity type, and by etching to form an upwardly tapering mesa (8), **characterized by** the following additional steps:

- reducing the cross section of the mesa (8) in the absorption region (4) and in part of the graded-index region (5) by selective etching, and
- reducing the entire cross section of the mesa (8) by attack-polishing, with the most material being removed at the edges (16, 17) formed by the selective etching.

6. Method of making an avalanche photodiode as claimed in claim 5, characterized by the following steps:
- depositing an n InP layer (3) on an n$^+$ InP substrate (3) by epitaxy;
- depositing an n$^-$ InGaAsP layer (4) by epitaxy;
- depositing the graded-index layer (5) with a composition from InGaAsP to InP by epitaxy;
- depositing an n InP layer (14) by epitaxy;
- changing the upper portion of the n InP layer (14) into a p$^+$ InP layer (7) by diffusion;
- depositing a metal contact (9) on the p$^+$ InP layer;
- patterning a mesa (8) using a photoresist mask and an isotropic etching technique;
- reducing the cross section of the n$^-$ InGaAsP layer (4) and the cross section of part of the graded-index layer (5) by selective etching, and
- reducing the entire cross section of the mesa (8) by attack-polishing.

**Revendications**

1. Photodiode à avalanche, comprenant un substrat semiconducteur (2), une couche servant de zone d'absorption (4), une couche servant de zone de multiplication (6), toutes d'un type conducteur, et une couche (7) d'un autre type conducteur, les couches étant superposées suivant l'ordre de succession cité et réalisées sous forme de mesa (8), caractérisée en ce que la mesa, observée depuis le substrat semiconducteur (2) et pour une hauteur croissante, comporte un élargissement (13), au moins partiellement dans la zone de multiplication (6), de façon que les claquages électriques de bordure soient réduits.

2. Photodiode à avalanche selon la revendication 1, caractérisée en ce que la mesa (8) comporte un surplomb, dans la zone de multiplication (6) et, au moins partiellement, dans la couche (7) composée d'un autre type conducteur.

3. Photodiode à avalanche selon la revendication 1 ou 2, caractérisée en ce que le substrat semiconducteur est un substrat de type n$^+$-inP (2) et en ce que la lumière à détecter est de préférence susceptible d'être rayonnée dans le substrat de type n$^+$-inP (2).

4. Photodiode à avalanche selon l'une des revendications 1 à 3, caractérisée en ce que sont disposées, sur le substrat n$^+$-inP (2) une couche de type n$^-$InP (3) servant de zone tampon, par dessus une couche n$^-$-InGaAsP (4), servant de zone d'absorption, par dessus une couche gradient (5) de composition différente, qui va de la couche InGaAsP à InP, à titre de couche intermédiaire, par dessus une couche n-InP (6) servant de zone de multiplication et, par-dessus, une couche p$^+$-InP (7), en ce que, sur la couche supérieure, sont disposés un contact métallique (9) et une couche de passivation (12) qui recouvre la totalité des couches de semiconducteur, et en ce que sur la face arrière du substrat n$^+$-InP (2) est disposé un contact métallique (11) avec une ouverture circulaire qui entoure une couche antiréflexion (10).

5. Procédé de fabrication d'une photodiode à avalanche selon la revendication 1, par application d'une couche servant de zone tampon (3), d'une couche servant de zone d'absorption (4), d'une couche gradient (5) et d'une couche supplémentaire (14), sur un substrat semiconducteur (2), toutes les couches étant d'un type conducteur et disposées superposées dans l'ordre de succession indiqué, passant d'un premier type conducteur à un deuxième type conducteur, par dopage de la partie supérieure de la couche supplémentaire (14), pour créer une zone de multiplication (6) d'un type conducteur et une couche (7) d'un autre type conducteur, et par attaque chimique, une mesa (8) qui s'effile vers le haut, caractérisée par les étapes de procédé supplémentaires:

- réduction de la section transversale de la mesa (8) dans la région de la zone d'absorption (4) et, partiellement, dans la couche gradient (5), par attaque chimique sélective,
- réduction de l'ensemble de la section transversale de la mesa (8), par attaque chimique de polissage, où l'on procède à une destruction aussi forte que possible des arêtes (16,17) apparues à l'occasion de l'attaque sélective.

6. Procédé de fabrication d'une photodiode à avalanche selon la revendication 5, caractérisée par les étapes de procédé suivantes:

- application d'une couche n-InP (3) sur un substrat n$^+$-InP (2) par épitaxie,
- application d'une couche n$^-$-InPGaAsP (4) par épitaxie,
- application de la couche gradient (5) présentant une composition allant de InGaAsP à InP, par épitaxie,
- application d'une couche n-InP (14) par épitaxie,
- réalisation de la partie supérieure de la couche n-InP (14) en une couche p$^+$-InP (7) par diffusion,
- application d'un contact métallique (9) sur la couche p$^+$-InP,
- structuration d'une mésa (8) à l'aide d'un recouvrement par une laque photosensible et par attaque chimique isotropique,
- réduction de la section transversale de la couche n$^-$-nGaAsP (4) et, partiellement, de la section transversale de la couche gradient (5), par attaque chimique sélective,
- réduction de l'ensemble de la section transversale de la mesa (8), par attaque chimique de polissage.

1

8

9

7

15

6

12

13

5

4

3

10

11

2

FIG.1

FIG.2

FIG.3